# EUROPEAN PATENT APPLICATION

(11) **EP 4 131 370 A1**
(43) Date of publication of application: **08.02.2023**
(21) Application number: 21780660.3
(22) Date of filing: 18.03.2021
(51) Int. Cl.: H01L 23/48, H01L 25/07, H01L 25/18

(54) **SEMICONDUCTOR MODULE**

(30) Priority: 01.04.2020 JP 2020065452
(71) Applicant: Panasonic Intellectual Property Management Co., Ltd., Osaka-shi, Osaka 540-6207 (JP)
(72) Inventor: KIMURA, Junichi, Chuo-ku, Osaka-shi, Osaka 540-6207 (JP); KAIBARA, Kazuhiro, Chuo-ku, Osaka-shi, Osaka 540-6207 (JP); HOZUMI, Norimitsu, Chuo-ku, Osaka-shi, Osaka 540-6207 (JP); DEGUCHI, Koutaro, Chuo-ku, Osaka-shi, Osaka 540-6207 (JP); MATSUMOTO, Atsushi, Chuo-ku, Osaka-shi, Osaka 540-6207 (JP)
(74) Representative: Novagraaf International SA
(86) International application number: PCT/JP2021/011065
(87) International publication number: WO 2021/200211

(57) **Abstract**

A semiconductor module includes: a first switch element; a second switch element; a first conductor that is joined to the source electrode of the first switch element, the first switch element is placed on the first conductor; a second conductor that is joined to the source electrode of the second switch element, the second switch element is placed on the second conductor; a positive electrode conductor connected to the drain electrode of the first switch element; an output conductor connected to the first conductor and the drain electrode of the second switch element; a negative electrode conductor connected to the second conductor; a first control conductor connected to the gate electrode of the first switch element; a second control conductor connected to the gate electrode of the second switch element; a first voltage detection terminal provided on the first conductor; a second voltage detection terminal provided on the second conductor; and an exterior resin part having a polyhedral shape. The first voltage detection terminal and the second voltage detection terminal protrude from different exterior surfaces of the exterior resin part.

## Description

### TECHNICAL FIELD

The present disclosure relates to semiconductor modules used for various electronic devices.

### BACKGROUND ART

A conventional semiconductor module will be described below. A conventional semiconductor module which includes: a positive potential switch element connected to a positive potential end of a direct-current power supply; and a negative potential switch element connected to a negative potential end of the direct-current power supply is configured to be able to output alternating-current power from a connection point between the positive potential switch element and the negative potential switch element. At the time when the semiconductor module operates, a voltage detection terminal connected to the positive potential switch element and a voltage detection terminal connected to the negative potential switch element are used to detect a voltage applied to the positive potential switch element and a voltage applied to the negative potential switch element, making it possible to grasp an operating state of the semiconductor module.

Note that Patent Literature (PTL) 1, for example, is known as related art document information pertaining to the present application.

### Citation List

### Patent Literature

PTL 1: Unexamined Japanese Patent Publication No. 2015-115464

### SUMMARY OF THE INVENTION

In the conventional semiconductor module, when the positive potential switch element and the negative potential switch element are arranged close to each other, the voltage detection terminal connected to the positive potential switch element and the voltage detection terminal connected to the negative potential switch element are positioned close to each other. This results in poor insulation between the positive potential switch element and the negative potential switch element. The conventional semiconductor module has reduced reliability, which is problematic.

A semiconductor module according to one aspect of the present disclosure includes: a first switch element including a source electrode, a gate electrode, and a drain electrode; a second switch element including a source electrode, a gate electrode, and a drain electrode; a first conductor that has a shape of a plate and is joined to the source electrode of the first switch element, the first switch element is placed on the first conductor; a second conductor that has a shape of a plate and is joined to the source electrode of the second switch element, the second switch element is placed on the second conductor; a positive electrode conductor connected to the drain electrode of the first switch element; an output conductor connected to the first conductor and the drain electrode of the second switch element; a negative electrode conductor connected to the second conductor; a first control conductor connected to the gate electrode of the first switch element; a second control conductor connected to the gate electrode of the second switch element; a first voltage detection terminal provided on the first conductor; a second voltage detection terminal provided on the second conductor; and an exterior resin part having a polyhedral shape and configured to seal the first switch element, the second switch element, the first conductor, the second conductor, a portion of the positive electrode conductor, a portion of the output conductor, a portion of the negative electrode conductor, a portion of the first control conductor, a portion of the second control conductor, a portion of the first voltage detection terminal, and a portion of the second voltage detection terminal. The exterior resin part includes a first exterior surface and a second exterior surface. The first voltage detection terminal protrudes from the first exterior surface. The second voltage detection terminal protrudes from the second exterior surface.

### BRIEF DESCRIPTION OF THE DRAWINGS

Fig. 1 is a schematic diagram illustrating a semiconductor module according to an exemplary embodiment of the present disclosure.
Fig. 2 is a top view illustrating a portion of a semiconductor module according to an exemplary embodiment of the present disclosure.
Fig. 3 is a top view illustrating a portion of a semiconductor module according to an exemplary embodiment of the present disclosure.
Fig. 4 is a perspective view illustrating a semiconductor module according to an exemplary embodiment of the present disclosure.
Fig. 5 is a schematic diagram illustrating the configuration of a power supply system including a semiconductor module according to an exemplary embodiment of the present disclosure.
Fig. 6 is a cross-sectional view illustrating a portion of the configuration of a semiconductor module according to an exemplary embodiment of the present disclosure.
Fig. 7 is a cross-sectional view illustrating a portion of the configuration of a semiconductor module according to a variation of an exemplary embodiment of the present disclosure.

### DESCRIPTION OF EMBODIMENTS

Hereinafter, an exemplary embodiment of the present disclosure will be described with reference to the drawings.

### EXEMPLARY EMBODIMENT

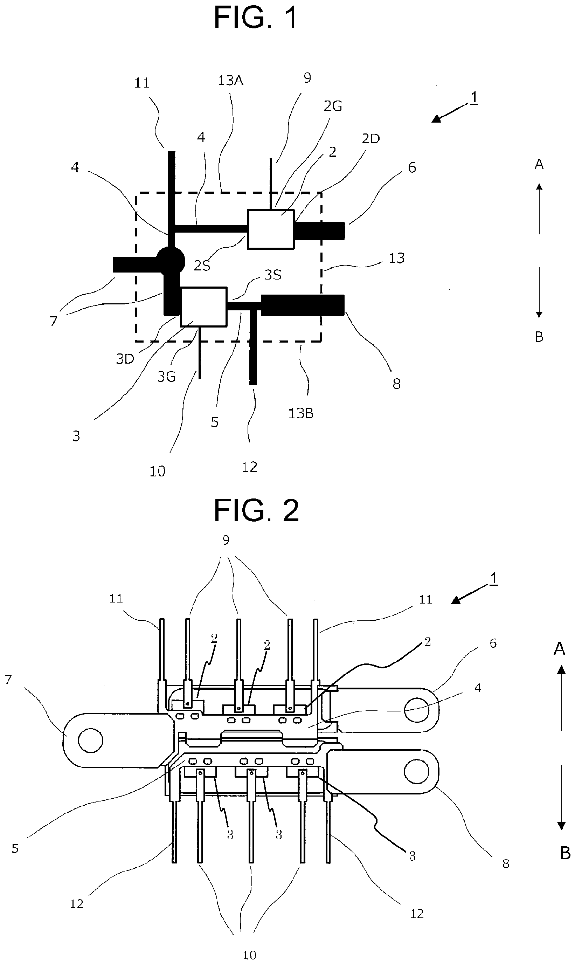

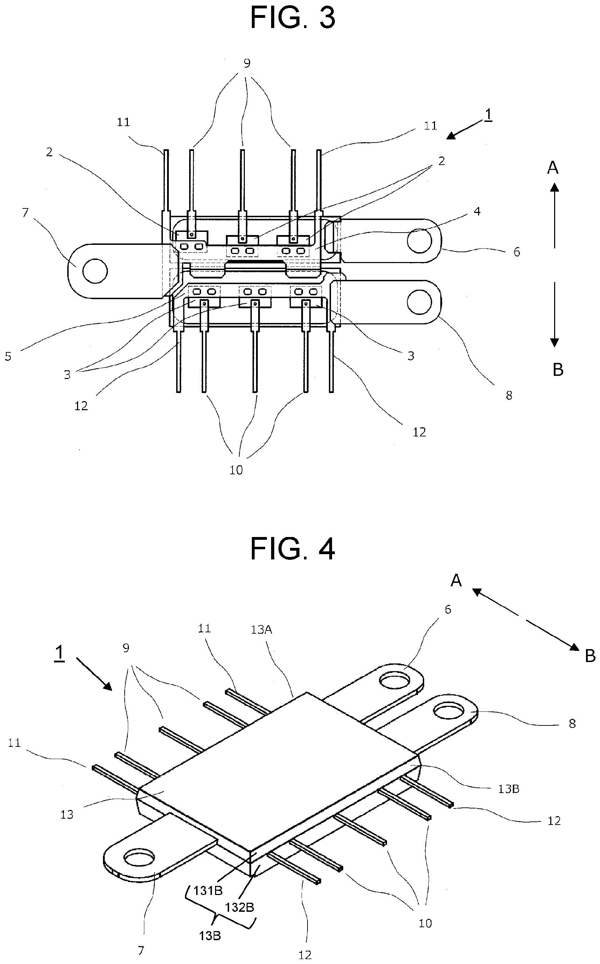

Fig. 1 is a schematic diagram illustrating a semiconductor module according to an exemplary embodiment of the present disclosure. Fig. 2 is a top view illustrating a portion of the semiconductor module according to the exemplary embodiment of the present disclosure. Fig. 3 is a top view illustrating a portion of the semiconductor module according to the exemplary embodiment of the present disclosure. Fig. 4 is a perspective view of the semiconductor module according to the exemplary embodiment of the present disclosure.

### [General Configuration of Semiconductor Module]

The general configuration of the semiconductor module will be described with reference to Fig. 1.

Semiconductor module 1 includes switch elements 2, 3, lead frames 4, 5, positive electrode lead frame 6, output lead frame 7, negative electrode lead frame 8, control lead frames 9, 10, first voltage detection terminal 11, second voltage detection terminal 12, and exterior resin part 13. Switch element 2 and switch element 3 each include a semiconductor. Note that in the exemplary embodiment, the term "lead frame" is used in the description, but there are cases where the "lead frame" is referred to as a "conductor."

Switch element 2 includes source electrode 2S, gate electrode 2G, and drain electrode 2D. Second switch element 3 includes source electrode 3S, gate electrode 3G, and drain electrode 3D.

Switch element 2 is placed on lead frame 4 with source electrode 2S joined thereto. Lead frame 4 is formed in the shape of a plate. Switch element 3 is placed on lead frame 5 with source electrode 3S joined thereto. Lead frame 5 is formed in the shape of a plate.

Positive electrode lead frame 6 is connected to drain electrode 2D of switch element 2. Output lead frame 7 is connected to each of lead frame 4 and drain electrode 3D of switch element 3. Negative electrode lead frame 8 is connected to lead frame 5.

Control lead frame 9 is connected to gate electrode 2G of switch element 2. Control lead frame 10 is connected to gate electrode 3G of switch element 3. First voltage detection terminal 11 is connected to lead frame 4. Second voltage detection terminal 12 is connected to lead frame 5.

### [Specific Example of Configuration of Semiconductor Module 1]

Next, with reference to Fig. 2 to Fig. 4, one example of the configuration of semiconductor module 1 will be described. Note that in the schematic diagram illustrated in Fig. 1, one switch element 2 and one switch element 3 are illustrated, but in a specific example of semiconductor module 1 illustrated in Fig. 2 to Fig. 4, switch element 2 is made up of three switch elements 2, and switch element 3 is made up of three switch elements 3. Thus, in Fig. 2 to Fig. 4, semiconductor module 1 includes three control lead frames 9 and three control lead frames 10.

Note that in Fig. 2 and Fig. 3, exterior resin part 13 is not illustrated to facilitate understanding of the configuration of semiconductor module 1.

Exterior resin part 13 (refer to Fig. 4) has a polyhedral shape. Exterior resin part 13 seals switch element 2, switch element 3, lead frame 4, and lead frame 5 in the state of avoiding exposure to the outside. Exterior resin part 13 seals a portion of positive electrode lead frame 6, a portion of output lead frame 7, a portion of negative electrode lead frame 8, a portion of control lead frame 9, a portion of control lead frame 10, a portion of first voltage detection terminal 11, and a portion of second voltage detection terminal 12.

As illustrated in Fig. 2 and Fig. 3, in the present exemplary embodiment, first voltage detection terminal 11 and lead frame 4 are formed of a single conductor, and first voltage detection terminal 11 is provided on lead frame 4. Second voltage detection terminal 12 and lead frame 5 are formed of a single conductor, and second voltage detection terminal 12 is provided on lead frame 5. However, first voltage detection terminal 11 and lead frame 4 may be formed of different members, and second voltage detection terminal 12 and lead frame 5 may be formed of different members.

As illustrated in Fig. 4, first exterior surface 13A and second exterior surface 13B oppose each other. First voltage detection terminal 11 protrudes from first exterior surface 13A in direction A, and second voltage detection terminal 12 protrudes from second exterior surface 13B in direction B. Direction A and direction B are opposite to each other; first voltage detection terminal 11 and second voltage detection terminal 12 are drawn out from exterior resin part 13 in opposite directions.

Note that first exterior surface 13A and second exterior surface 13B do not need to be completely opposite surfaces; it is sufficient that first exterior surface 13A and second exterior surface 13B be located substantially opposite to each other. Furthermore, the directions in which first voltage detection terminal 11 and second voltage detection terminal 12 are drawn out do not need to be completely opposite to each other; it is sufficient that first voltage detection terminal 11 and second voltage detection terminal 12 be drawn out in substantially opposite directions.

Note that each of first exterior surface 13A and second exterior surface 13B does not necessarily need to be formed of a single flat surface. For example, as illustrated in Fig. 4, second exterior surface 13B includes first surface 131B and second surface 132B. First surface 131B and second surface 132B are not arranged in parallel; first surface 131B and second surface 132B form an obtuse angle. Similar to second exterior surface 13B, first exterior surface 13A includes two surfaces that form an obtuse angle.

Even when each of first exterior surface 13A and second exterior surface 13B is not a single flat surface as illustrated in Fig. 4, first exterior surface 13A and second exterior surface 13B are regarded as opposing each other in the present disclosure.

As illustrated in Fig. 3, the linear distance between first voltage detection terminal 11 and second voltage detection terminal 12 is short. However, as illustrated in Fig. 4, a portion of first voltage detection terminal 11 and second voltage detection terminal 12 are sealed by exterior resin part 13, and thus the creepage distance between first voltage detection terminal 11 and second voltage detection terminal 12 is greater than said linear distance.

Similarly, even though the linear distance between lead frame 4 and lead frame 5 is short (refer to Fig. 3), the creepage distance between lead frame 4 and lead frame 5 is greater than said linear distance as a result of a portion of lead frame 4 and a portion of lead frame 5 being sealed by exterior resin part 13.

Thus, with the above-described configuration, it is possible to minimize deterioration of the insulation between switch element 2 and switch element 3, allowing for increased reliability of semiconductor module 1.

### [Configuration of Power Supply System 14]

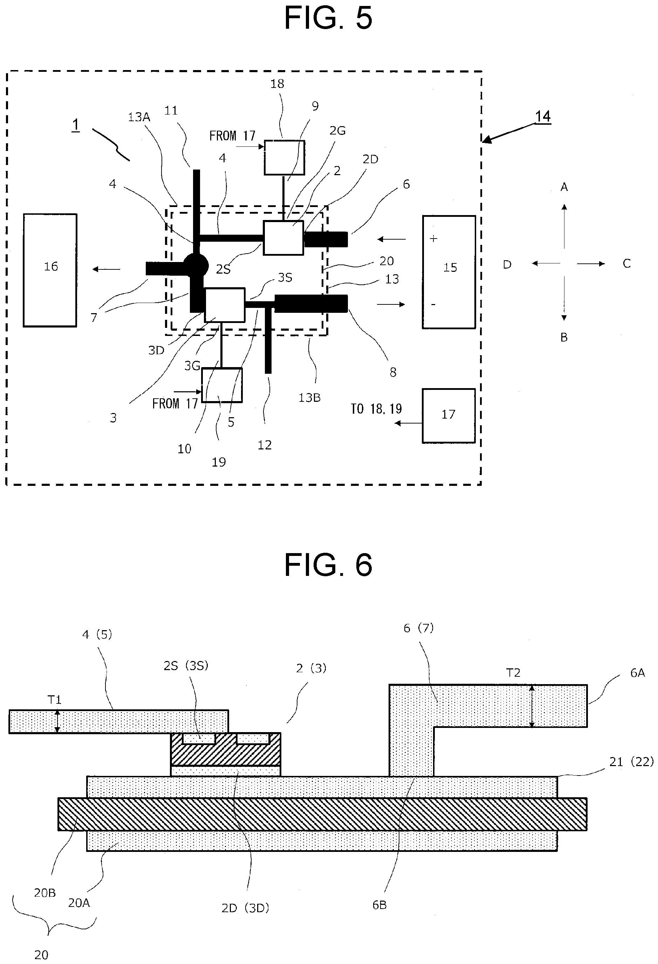

Next, the configuration of power supply system 14 including semiconductor module 1 described above will be described with reference to Fig. 5. Power supply system 14 includes semiconductor module 1, direct-current power supply device 15, load device 16, control circuit 17, and gate drivers 18, 19.

Direct-current power supply device 15 applies a voltage having a positive potential to positive electrode lead frame 6 of semiconductor module 1. Direct-current power supply device 15 applies a voltage having a negative potential to negative electrode lead frame 8 of semiconductor module 1. With switch element 2 and switch element 3 repeatedly turning ON and OFF in an alternate manner, load device 16 receives alternating-current power supplied from output lead frame 7. Control circuit 17 can control the supply of electric power to load device 16 by controlling gate drivers 18, 19 on the basis of the voltages detected by first voltage detection terminal 11 and second voltage detection terminal 12. Load device 16 is, for example, an alternating-current motor. Although not described in detail herein, when load device 16 is a three-phase motor, three semiconductor modules 1 are preferably provided corresponding to the U phase, the V phase, and the W phase.

As explained earlier, semiconductor module 1 includes switch element 2, switch element 3, lead frame 4, lead frame 5, positive electrode lead frame 6, output lead frame 7, negative electrode lead frame 8, control lead frame 9, control lead frame 10, first voltage detection terminal 11, second voltage detection terminal 12, and exterior resin part 13. Switch elements 2, 3, lead frames 4, 5, positive electrode lead frame 6, output lead frame 7, negative electrode lead frame 8, control lead frame 9, control lead frame 10, first voltage detection terminal 11, and second voltage detection terminal 12 are directly or indirectly placed on insulator/radiator 20. Switch elements 2, 3, lead frames 4, 5, positive electrode lead frame 6, output lead frame 7, negative electrode lead frame 8, control lead frame 9, control lead frame 10, first voltage detection terminal 11, and second voltage detection terminal 12, which are directly or indirectly placed on insulator/radiator 20, are partially or entirely sealed by exterior resin part 13.

Each of positive electrode lead frame 6, output lead frame 7, and negative electrode lead frame 8 has a cross-sectional area larger in a direction in which electric power is supplied than that of each of lead frames 4, 5. Having a large cross-sectional area in a direction in which electric power is supplied leads to improved thermal propagation properties as well as reduced electrical resistance. With this configuration, semiconductor module 1 can be mechanically fixed to direct-current power supply device 15 and load device 16 with high fixing strength maintained.

The shape of exterior resin part 13 illustrated in Fig. 4 is one example of the shape of the exterior resin part. The shape of exterior resin part 13 illustrated in Fig. 4 is roughly a hexahedron. Note that for convenience in a molding step, etc., exterior resin part 13 may include a chamfered area in a portion of first exterior surface 13A, second exterior surface 13B, and the like, or may include a curved portion between surfaces, for example. Even in this case, exterior resin part 13 may be handled as a hexahedron. As mentioned above, each of first exterior surface 13A and second exterior surface 13B does not necessarily need to be a single flat surface.

The shape of exterior resin part 13 will be described using second exterior surface 13B. Second exterior surface 13B includes first surface 131B and second surface 132B. First surface 131B and second surface 132B are provided at different angles; first surface 131B and second surface 132B form an obtuse angle. Similar to second exterior surface 13B, first exterior surface 13A includes two surfaces that form an obtuse angle.

In other words, exterior resin part 13 does not need to be a complete hexahedron. Exterior resin part 13 does not need to have a polyhedral shape formed of a plurality of flat surfaces only. Exterior resin part 13 may be a polyhedron formed by a plurality of flat surfaces and a plurality of curved surfaces.

Exterior resin part 13 seals switch element 2, switch element 3, lead frame 4, and lead frame 5 in the state of avoiding exposure to the outside. Exterior resin part 13 seals a portion of positive electrode lead frame 6, a portion of output lead frame 7, a portion of negative electrode lead frame 8, a portion of control lead frame 9, a portion of control lead frame 10, a portion of first voltage detection terminal 11, and a portion of second voltage detection terminal 12. A portion of positive electrode lead frame 6, a portion of output lead frame 7, a portion of negative electrode lead frame 8, a portion of control lead frame 9, a portion of control lead frame 10, a portion of first voltage detection terminal 11, and a portion of second voltage detection terminal 12 are exposed from exterior resin part 13.

Insulator/radiator 20 is not exposed to the outside of exterior resin part 13 and is entirely sealed by exterior resin part 13. Note that insulator/radiator 20 may include a portion exposed to the outside of exterior resin part 13.

Switch element 2 includes source electrode 2S, gate electrode 2G, and drain electrode 2D. Switch element 3 includes source electrode 3S, gate electrode 3G, and drain electrode 3D. Each of switch elements 2, 3 is a longitudinal semiconductor switch element of a metal-oxide-film-type field-effect transistor (MOSFET).

Next, the configuration of the switch element will be described with reference to Fig. 6.

As illustrated in Fig. 6, in switch element 2, source electrode 2S is provided on the upper surface of switch element 2. Although not illustrated in Fig. 6, gate electrode 2G is also provided on the upper surface of the switch element. This means that source electrode 2S and gate electrode 2G are formed on the same surface. Meanwhile, drain electrode 2D is provided on the lower surface of switch element 2. This means that drain electrode 2D is formed on the surface opposite to the surface on which gate electrode 2G and source electrode 2S are formed.

As in switch element 2, in switch element 3, gate electrode 3G and source electrode 3 S are formed on the same surface, and drain electrode 3D is formed on the surface opposite to the surface on which gate electrode 3G and source electrode 3S are formed.

As illustrated in Fig. 6, lead frame 4 is directly joined to source electrode 2S using a jointing material (not illustrated in the drawings), and lead frame 4 is placed on switch element 2. Similarly, lead frame 5 is directly joined to source electrode 3 S using a jointing material (not illustrated in the drawings), and switch element 3 is placed on lead frame 5. Lead frames 4, 5 are, for example, copper sheets each in the form of a plate or copper alloy sheets each in the form of a plate. For lead frames 4, 5, it is desirable to select shapes and materials that provide low-resistance, good thermal conduction properties with use of aluminum or the like. Lead frames 4, 5 do not need to be rectangular as long as lead frames 4, 5 are each in the form of a plate instead of being a conductor in the form of a foil or a line and may include a bent portion, a step portion, or the like.

Positive electrode lead frame 6 is connected to drain electrode 2D. Output lead frame 7 is connected to lead frame 4 and drain electrode 3D. Instead of using wire bonding, jointing materials (not illustrated in the drawings) are used to directly connect drain electrode 2D and drain electrode 3D to positive electrode lead frame 6 and output lead frame 7, respectively. A jointing material (not illustrated in the drawings), a conductor layer (not illustrated in the drawings), or a conductor plate (not illustrated in the drawings) may be interposed between drain electrode 2D and positive electrode lead frame 6 upon connection. A jointing material (not illustrated in the drawings), a conductor layer (not illustrated in the drawings), or a conductor plate (not illustrated in the drawings) may be interposed between drain electrode 3D and output lead frame 7 upon connection.

It is sufficient that each of the conductor layer (not illustrated in the drawings) and the conductor plate (not illustrated in the drawings) be a high-ampacity, low-resistance conductor having a large cross-sectional area in a direction in which electric power is supplied. It is sufficient that the connection between drain electrode 2D and positive electrode lead frame 6 be in the state of being joined with substantially no direct-current resistance therebetween. Similarly, it is sufficient that the connection between drain electrode 3D and output lead frame 7 be in the state of being joined with substantially no direct-current resistance therebetween.

It is sufficient that each of the conductor layer (not illustrated in the drawings) and the conductor plate (not illustrated in the drawings) have ampacity substantially equal to that of each of lead frame 4 and lead frame 5. It is sufficient that the cross-sectional area of each of the conductor layer (not illustrated in the drawings) and the conductor plate (not illustrated in the drawings) in a direction in which electric power is supplied be substantially equal to that of each of lead frame 4 and lead frame 5. The connection between drain electrode 2D and positive electrode lead frame 6 may be direct connection or may be indirect connection as long as drain electrode 2D and positive electrode lead frame 6 have the same potential. The connection between drain electrode 3D and output lead frame 7 may be direct connection or may be indirect connection as long as drain electrode 3D and output lead frame 7 have the same potential.

With this configuration, loss due to the direct-current resistance between switch element 2 and positive electrode lead frame 6 can be minimized. Similarly, loss due to the direct-current resistance between switch element 3 and output lead frame 7 can be minimized. When switch element 2 and switch element 3 are connected to the conductors each having a large cross-sectional area, heat generated by switch element 2 and switch element 3 can be easily diffused to the outside of semiconductor module 1.

Positive electrode lead frame 6, a portion of output lead frame 7, and negative electrode lead frame 8 are, for example, copper or copper alloy sheets each in the form of a plate. For positive electrode lead frame 6, a portion of output lead frame 7, and negative electrode lead frame 8, it is desirable to select shapes and materials that provide low-resistance, good thermal conduction properties with use of aluminum or the like. Positive electrode lead frame 6, a portion of output lead frame 7, and negative electrode lead frame 8 do not need to be rectangular as long as positive electrode lead frame 6, a portion of output lead frame 7, and negative electrode lead frame 8 are each in the form of a plate instead of being a conductor in the form of a foil or a line and may include a bent portion, a step portion, or the like.

Fig. 6 is a partial cross-sectional view illustrating a portion of the configuration of semiconductor module 1. As illustrated in Fig. 6, in the present exemplary embodiment, positive electrode lead frame 6 and drain electrode 2D are not directly connected, but are connected via conductor layer 21 provided on insulator/radiator 20. It is desirable that the cross-sectional area of conductor layer 21 in a direction in which electric power is supplied be substantially equal to or larger than the cross-section area of positive electrode lead frame 6 in a direction in which electric power is supplied. The direct-current resistance between lead joining part 6B of positive electrode lead frame 6 and drain electrode 2D in conductor layer 21 is preferably lower than the direct-current resistance between distal end 6A and lead joining part 6B of positive electrode lead frame 6. With this configuration, even when positive electrode lead frame 6 and drain electrode 2D are not directly connected, the electric power loss between positive electrode lead frame 6 and drain electrode 2D is minimized. As explained earlier, the element connected to source electrode 2S is lead frame 4.

In Fig. 6, lead joining part 6B is illustrated as a portion of positive electrode lead frame 6, but lead joining part 6B may be formed of a welding material such as solder. Lead joining part 6B may be formed of a portion of positive electrode lead frame 6 melted by a method such as ultrasonic welding of positive electrode lead frame 6 without using a welding material different from positive electrode lead frame 6.

Conductor layer 21 is desirably a copper sheet or a copper alloy sheet or made of a low-resistance material such as aluminum. Insulator/radiator 20 includes stacked insulating layer 20A and metal layer 20B provided on the lower surface of insulating layer 20A. Insulating layer 20A is preferably made of ceramic or the like which has high thermal conductivity, and metal layer 20B is preferably made of copper, a copper alloy, aluminum, or the like.

Fig. 6 illustrates the relationship between positive electrode lead frame 6, conductor layer 21, switch element 2, and lead frame 4. Fig. 6 further illustrates the relationship between positive electrode lead frame 6, conductor layer 22, switch element 3, and lead frame 5.

Control lead frame 9 is connected to gate electrode 2G. Control lead frame 10 is connected to gate electrode 3G. It is preferable that control lead frame 9 and gate electrode 2G be directly connected by a jointing material (not illustrated in the drawings) without using wire bonding. Similarly, it is preferable that control lead frame 10 and gate electrode 3G be directly connected by a jointing material (not illustrated in the drawings) without using wire bonding. Signals that are transmitted from gate driver 18 to switch element 2 and signals that are transmitted from gate driver 19 to switch element 3 are subject to the pulse-width modulation (PWM) control or the like and include a large number of high-frequency components. Therefore, when control lead frame 9 is directly connected to gate electrode 2G without using wire bonding, the transmission distance of the signals is shortened, noise interference or the like is suppressed, and the operation reliability of semiconductor module 1 increases. Similarly, when control lead frame 10 is directly connected to gate electrode 3G without using wire bonding, the transmission distance of the signals is shortened, noise interference or the like is suppressed, and the operation reliability of semiconductor module 1 increases.

Since the signals that are transmitted from gate driver 18 to switch element 2 and the signal that are transmitted from gate driver 19 to switch element 3 have small electriccurrent values, the cross-sectional area of control lead frame 9 in a direction in which electric power is supplied and the cross-sectional area of control lead frame 10 in a direction in which electric power is supplied may have values smaller than the values of the cross-sectional area of positive electrode lead frame 6 in a direction in which electric power is supplied, the cross-sectional area of output lead frame 7 in a direction in which electric power is supplied, and the cross-sectional area of negative electrode lead frame 8 in a direction in which electric power is supplied.

First voltage detection terminal 11 is connected to lead frame 4. Second voltage detection terminal 21 is connected to lead frame 5. First voltage detection terminal 11 and lead frame 4 are formed of a single conductor, and second voltage detection terminal 12 and lead frame 5 are formed of a single conductor. In other words, first voltage detection terminal 11 and lead frame 4 are electrically connected to each other with no joint or wire bonding therebetween. Second voltage detection terminal 12 and lead frame 5 are electrically connected to each other with no joint or wire bonding therebetween.

First voltage detection terminal 11 is provided in order to monitor the operating state of switch element 2. Second voltage detection terminal 12 is provided in order to monitor the operating state of switch element 3. The state of connection between first voltage detection terminal 11 and lead frame 4 and the state of connection between second voltage detection terminal 12 and lead frame 5 are extremely stable. Thus, even when external mechanical or thermal stress is applied to semiconductor module 1, the operating state of semiconductor module 1 can be accurately output to the outside, leading to increased reliability of semiconductor module 1. First voltage detection terminal 11 integrated with lead frame 4 through which an electric current having a large value tends to flow and which is easily heated is exposed from exterior resin part 13, making it easy for lead frame 4 to cool down. Thus, the operation reliability of semiconductor module 1 increases. This is also true for lead frame 5 and second voltage detection terminal 12.

First voltage detection terminal 11 and second voltage detection terminal 12 are drawn out from different exterior surfaces (first exterior surface 13A and second exterior surface 13B) of exterior resin part 13. In particular, first voltage detection terminal 11 is drawn out from first exterior surface 13A of exterior resin part 13 in direction A, and second voltage detection terminal 12 is drawn out from second exterior surface 13B of exterior resin part 13, which opposes first exterior surface 13A, in direction B opposite to direction A.

The linear distance between first voltage detection terminal 11 and second voltage detection terminal 12 is short. However, in the above-described configuration, a portion of first voltage detection terminal 11 and a portion of second voltage detection terminal 12 are sealed by exterior resin part 13, and thus the creepage distance between first voltage detection terminal 11 and second voltage detection terminal 12 is greater than said linear distance.

With this configuration, it is possible to minimize deterioration of the insulation between switch element 2 and switch element 3, allowing for increased reliability of semiconductor module 1.

Note that second voltage detection terminal 12 may be omitted when a high-potential voltage detection terminal connected to positive electrode lead frame 6 is drawn out from first exterior surface 13A and first voltage detection terminal 11 is drawn out from second exterior surface 13B. Even in this configuration, the creepage distance between the high-potential voltage detection terminal (not illustrated in the drawings) and first voltage detection terminal 11 is greater than the linear distance between the high-potential voltage detection terminal (not illustrated in the drawings) and first voltage detection terminal 11. This means that the high-potential voltage detection terminal (not illustrated in the drawings) and first voltage detection terminal 11 are separated by the distance between first exterior surface 13A and second exterior surface 13B. As a result, it is possible to minimize deterioration of the insulation between switch element 2 and switch element 3, allowing for increased reliability of semiconductor module 1.

In semiconductor module 1 described above, single switch element 2 and single switch element 3 are provided, single control lead frame 9 and single control lead frame 10 are provided, and furthermore single first voltage detection terminal 11 and single second voltage detection terminal 12 are provided.

However, in semiconductor module 1, a plurality of switch elements 2 may be connected and arranged in parallel, and furthermore a plurality of switch elements 3 may be provided, as illustrated in Fig. 2, etc.

In the case where a plurality of switch elements 2 are provided, a plurality of control lead frames 9 are arranged. Similarly, in the case where a plurality of switch elements 3 are provided, a plurality of control lead frames 10 are provided. In the case where a plurality of first voltage detection terminals 11 are provided, at least one first voltage detection terminal 11 is used to detect a voltage. Similarly, in the case where a plurality of second voltage detection terminals 12 are provided, at least one second voltage detection terminal 12 is used to detect a voltage.

Lead frame 4 and lead frame 5 are preferably arranged side by side. As a result of switch element 2 and switch element 3 repeatedly turning ON and OFF in an alternate manner, an electric current flows through lead frame 4 in direction C (refer to Fig. 5), and an electric current flows through lead frame 5 in direction D (refer to Fig. 5). Therefore, with lead frame 4 and lead frame 5 arranged side by side in a direction orthogonal to a direction in which lead frame 4 and lead frame 5 extend, inductance components that are generated at lead frame 4 and lead frame 5 can be cancelled out and thus reduced, and electric power loss that occurs in semiconductor module 1 can be reduced.

Lead frame 4 and lead frame 5 preferably have similar shapes each in the form of a plate. It is desirable that lead frame 4 and lead frame 5 be arranged so as to extend in parallel. However, these conditions do not need to be completely satisfied regarding a reduction in the above-described inductance components. Even when portions of lead frame 4 and lead frame 5 are arranged roughly in parallel, inductance components that are generated at lead frame 4 and lead frame 5 can be cancelled out and thus reduced, and electric power loss that occurs in semiconductor module 1 can be reduced.

Control lead frame 9 is preferably drawn out in the same direction as first voltage detection terminal 11 as illustrated in Fig. 4. In this case, first voltage detection terminal 11 and control lead frame 9 are drawn out from the same exterior surface (first exterior surface 13A). This is also true for control lead frame 10 and second voltage detection terminal 12; second voltage detection terminal 12 and control lead frame 10 are drawn from the same exterior surface (second exterior surface 13B). First exterior surface 13A and second exterior surface 13B oppose each other.

With this configuration, gate driver 18 connected to control lead frame 9 and gate driver 19 connected to control lead frame 10 can be disposed away from each other, as illustrated in Fig. 5. As a result, positioning of gate driver 18 and gate driver 19 has a high degree of flexibility, and the design flexibility of semiconductor module 1 is also high. Furthermore, the distance between switch element 2 and gate driver 18 and the distance between switch element 3 and gate driver 19 can be made short. As a result, the transmission distance of the signals is shortened, and thus noise interference or the like is suppressed, leading to increased operation reliability of semiconductor module 1.

A substrate (not illustrated in the drawings) on which gate driver 18, gate driver 19, and control circuit 17 are mounted and a substrate (not illustrated in the drawings) on which semiconductor module 1 is mounted are different; these substrates are preferably provided in layers so as to face each other in parallel.

Furthermore, it is preferable that control lead frame 9 and first voltage detection terminal 11 be drawn out from first exterior surface 13A and bent toward the substrate (not illustrated in the drawings) on which gate driver 18, gate driver 19, and control circuit 17 are mounted. In other words, control lead frame 9 and first voltage detection terminal 11 are drawn out from first exterior surface 13A roughly in parallel with the substrate (not illustrated in the drawings) on which semiconductor module 1 is mounted.

Similarly, it is preferable that control lead frame 10 and second voltage detection terminal 12 be drawn out from second exterior surface 13B and bent toward the substrate (not illustrated in the drawings) on which gate driver 18, gate driver 19, and control circuit 17 are mounted. In other words, control lead frame 10 and second voltage detection terminal 12 are drawn out from second exterior surface 13B roughly in parallel with the substrate (not illustrated in the drawings) on which semiconductor module 1 is mounted.

With this configuration, control lead frame 9 and control lead frame 10 are positioned at a distance outside exterior resin part 13. Similarly, first voltage detection terminal 11 and second voltage detection terminal 12 are positioned at a distance. As a result, it is possible to minimize deterioration of the insulation between switch element 2 and switch element 3, allowing for increased reliability of semiconductor module 1.

As mentioned earlier, each of positive electrode lead frame 6, output lead frame 7, and negative electrode lead frame 8 is preferably shaped such that the cross-sectional area thereof, particularly in a direction in which electric power is supplied, is larger than that of each of lead frame 4 and lead frame 5. The cross-sectional area of each of control lead frame 9 and control lead frame 10 in a direction in which electric power is supplied preferably has a smaller value than the cross-sectional area of each of positive electrode lead frame 6, output lead frame 7, and negative electrode lead frame 8 in a direction in which electric power is supplied.

In Fig. 5, positive electrode lead frame 6, output lead frame 7, and negative electrode lead frame 8 are wider than lead frame 4 and lead frame 5 as viewed from above.

The thickness of positive electrode lead frame 6 may be greater than the thickness of lead frame 4, as illustrated in Fig. 6. Similarly, each of the thickness of output lead frame 7 and the thickness of negative electrode lead frame 8 may be greater than the thickness of lead frame 5. The thickness of control lead frame 9 and the thickness of control lead frame 10 may be less than the thickness of positive electrode lead frame 6, the thickness of output lead frame 7, and the thickness of negative electrode lead frame 8.

The thickness of lead frame 4 (denoted as T1 in Fig. 6), the thickness of lead frame 5, and the thickness of control lead frame 9 are preferably set equal to the thickness of control lead frame 10, and the thickness of positive electrode lead frame 6 (denoted as T2 in Fig. 6), the thickness of output lead frame 7, and the thickness of negative electrode lead frame 8 are preferably set to have a thickness (thickness T2) greater than thickness T1.

With this configuration, mechanical fixing strength required for positive electrode lead frame 6, output lead frame 7, and negative electrode lead frame 8 to fix to direct-current power supply device 15 and load device 16 is high. Obviously, thickness T1 which is the thickness of lead frame 4 and the thickness of lead frame 5 preferably has a value such that loss in semiconductor module 1 is minimized and lead frames 4, 5 have sufficient ampacity to avoid excessive heat generation or the like.

### VARIATION OF EXEMPLARY EMBODIMENT

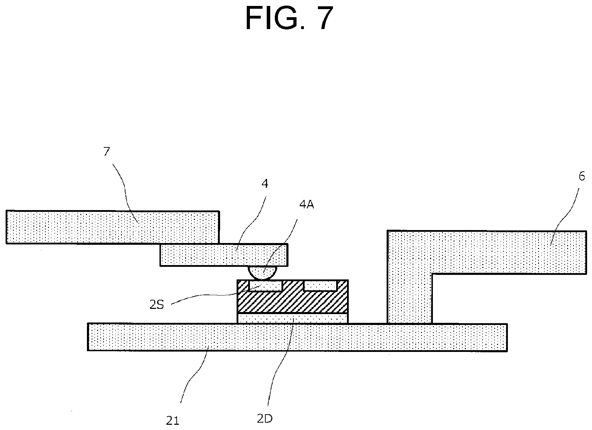

In semiconductor module 1 according to a variation illustrated in Fig. 7, lead frame 4 includes connecting convex portion 4A. Source electrode 2S is connected to connecting convex portion 4A provided on lead frame 4. Similar to lead frame 4, lead frame 5 includes a connecting convex portion, and source electrode 3S is connected to the connecting convex portion (not illustrated in the drawings) provided on lead frame 5.

Providing connecting convex portion 4A or the like on lead frame 4 makes it easy to accurately determine the position of a point at which lead frame 4 is joined to switch element 2. Connecting convex portion 4A allows switch element 2 to keep space or a creepage distance in a portion that requires insulation.

Obviously, a region in which the aforementioned space is provided may be filled with exterior resin part 13. Furthermore, connecting convex portion 4A contacts source electrode 2S in a small region. Therefore, a jointing material, a welding material, or the like is used to stabilize the joint between connecting convex portion 4A and source electrode 2S, leading to increased reliability of semiconductor module 1.

Note that although only source electrode 2S and switch element 2 have been thus far described in detail, the same is true for source electrode 3S and switch element 3.

In the above description, single switch element 2 and single switch element 3 are used to simplify the description, but in order to increase ampacity, two or more switch elements 2 and two or more switch elements 3 may be arranged in parallel and controlled so as to operate in synchronization, as illustrated in Fig. 2 and Fig. 3.

### CLOSING

Semiconductor module 1 according to one aspect of the present disclosure includes: switch element 2 including source electrode 2S, gate electrode 2G, and drain electrode 2D; switch element 3 including source electrode 3S, gate electrode 3G, and drain electrode 3D; lead frame 4 (conductor) that has a shape of a plate and is joined to source electrode 2S of switch element 2, switch element 3 is placed on lead frame 4; lead frame 5 (conductor) that has a shape of a plate and is joined to source electrode 3S of switch element 3, switch element 3 is placed on lead frame 5; positive electrode lead frame 6 (positive electrode conductor) connected to drain electrode 2D of switch element 2; output lead frame 7 (output conductor) connected to lead frame 4 and drain electrode 3D of switch element 3; negative electrode lead frame 8 (negative electrode conductor) connected to lead frame 5; control lead frame 9 (control conductor) connected to gate electrode 2G of switch element 2; control lead frame 10 (control conductor) connected to gate electrode 3G of switch element 3; first voltage detection terminal 11 provided on lead frame 4; second voltage detection terminal 12 provided on lead frame 5; and exterior resin part 13 having a polyhedral shape and configured to seal switch element 2, switch element 3, lead frame 4, lead frame 5, a portion of positive electrode lead frame 6, a portion of output lead frame 7, a portion of negative electrode lead frame 8, a portion of control lead frame 9, a portion of control lead frame 10, a portion of first voltage detection terminal 11, and a portion of second voltage detection terminal 12. Exterior resin part 13 includes first exterior surface 13A and second exterior surface 13B. First voltage detection terminal 11 protrudes from first exterior surface 13A. Second voltage detection terminal 12 protrudes from second exterior surface 13B.

In semiconductor module 1 according to another aspect, first voltage detection terminal 11 and lead frame 4 are a single conductor, and second voltage detection terminal 12 and lead frame 5 are a single conductor.

In semiconductor module 1 according to another aspect, first exterior surface 13A and second exterior surface 13B oppose each other.

In semiconductor module 1 according to another aspect, first exterior surface 13A includes two planes, and second exterior surface 13B includes two planes.

In semiconductor module 1 according to another aspect, a direction in which first voltage detection terminal 11 protrudes from first exterior surface 13A is opposite to a direction in which second voltage detection terminal 12 protrudes from second exterior surface 13B.

In semiconductor module 1 according to another aspect, lead frame 4 and lead frame 5 are arranged side by side.

In semiconductor module 1 according to another aspect, first voltage detection terminal 11 and control lead frame 9 protrude from first exterior surface 13A, and second voltage detection terminal 12 and control lead frame 10 protrude from second exterior surface 13B.

In semiconductor module 1 according to another aspect, each of the thickness of control lead frame 9, the thickness of control lead frame 10, the thickness of lead frame 4, and the thickness of lead frame 5 is thickness T1, each of the thickness of positive electrode lead frame 6, the thickness of output lead frame 7, and the thickness of negative electrode lead frame 8 is thickness T2, and the value of T2 is greater than the value of T1.

In semiconductor module 1 according to another aspect, lead frame 4 includes connecting convex part 4A, source electrode 2S of switch element 2 is connected to connecting convex part 4A of lead frame 4, and similar to lead frame 4, lead frame 5 includes a connecting convex part, and source electrode 3S of switch element 3 is connected to the connecting convex part of lead frame 5.

### INDUSTRIAL APPLICABILITY

The semiconductor module according to the present disclosure has the advantageous effect of allowing for increased reliability and is useful in various electronic devices.

### REFERENCE MARKS IN THE DRAWINGS

- 1: semiconductor module
- 2, 3: switch element
- 2G: gate electrode
- 2D: drain electrode
- 2S: source electrode
- 3G: gate electrode
- 3D: drain electrode
- 3S: source electrode
- 4, 5: lead frame
- 4A: connecting convex portion
- 6: positive electrode lead frame
- 6A: distal end
- 6B: lead joining part
- 7: output lead frame
- 8: negative electrode lead frame
- 9, 10: control lead frame
- 11: first voltage detection terminal
- 12: second voltage detection terminal
- 13: exterior resin part
- 13A: first exterior surface
- 13B: second exterior surface
- 14: power supply system
- 15: direct-current power supply device
- 16: load device
- 17: control circuit
- 18: gate driver
- 19: gate driver
- 20: insulator/radiator
- 20A: insulating layer
- 20B: metal layer
- 21: conductor layer
- 22: conductor layer

## Claims

1. A semiconductor module comprising:
a first switch element including a source electrode, a gate electrode, and a drain electrode;
a second switch element including a source electrode, a gate electrode, and a drain electrode;
a first conductor that has a shape of a plate and is joined to the source electrode of the first switch element, the first switch element is placed on the first conductor;
a second conductor that has a shape of a plate and is joined to the source electrode of the second switch element, the second switch element is placed on the second conductor;
a positive electrode conductor connected to the drain electrode of the first switch element;
an output conductor connected to the first conductor and the drain electrode of the second switch element;
a negative electrode conductor connected to the second conductor;
a first control conductor connected to the gate electrode of the first switch element;
a second control conductor connected to the gate electrode of the second switch element;
a first voltage detection terminal provided on the first conductor;
a second voltage detection terminal provided on the second conductor; and
an exterior resin part having a polyhedral shape and configured to seal the first switch element, the second switch element, the first conductor, the second conductor, a portion of the positive electrode conductor, a portion of the output conductor, a portion of the negative electrode conductor, a portion of the first control conductor, a portion of the second control conductor, a portion of the first voltage detection terminal, and a portion of the second voltage detection terminal, wherein
the exterior resin part includes a first exterior surface and a second exterior surface,
the first voltage detection terminal protrudes from the first exterior surface, and
the second voltage detection terminal protrudes from the second exterior surface.

2. The semiconductor module according to claim 1, wherein
the first voltage detection terminal and the first conductor are a single conductor, and
the second voltage detection terminal and the second conductor are a single conductor.

3. The semiconductor module according to claim 1 or 2, wherein
the first exterior surface and the second exterior surface oppose each other.

4. The semiconductor module according to claim 3, wherein
the first exterior surface includes two planes, and
the second exterior surface includes two planes.

5. The semiconductor module according to any one of claims 1 to 4, wherein a direction in which the first voltage detection terminal protrudes from the first exterior surface is opposite to a direction in which the second voltage detection terminal protrudes from the second exterior surface.

6. The semiconductor module according to any one of claims 1 to 5, wherein
the first conductor and the second conductor are arranged side by side.

7. The semiconductor module according to any one of claims 1 to 6, wherein
the first voltage detection terminal and the first control conductor protrude from the first exterior surface, and
the second voltage detection terminal and the second control conductor protrude from the second exterior surface.

8. The semiconductor module according to any one of claims 1 to 6, wherein
each of a thickness of the first control conductor, a thickness of the second control conductor, a thickness of the first conductor, and a thickness of the second conductor in one direction is a first value,
each of a thickness of the positive electrode conductor, a thickness of the output conductor, and a thickness of the negative electrode conductor in the one direction is a second value, and
the second value is greater than the first value.

9. The semiconductor module according to any one of claims 1 to 6, wherein
the first conductor includes a convex part,
the source electrode of the first switch element is connected to the convex part of the first conductor,
the second conductor includes a convex part, and
the source electrode of the second switch element is connected to the convex part of the second conductor.
